# EUROPEAN PATENT SPECIFICATION

(11) **EP 4 418 473 B1**
(45) Date of publication and mention of the grant of the patent: **22.07.2026**
(21) Application number: 23211564.2
(22) Date of filing: 22.11.2023
(51) Int. Cl.: H02B 1/28, H02B 1/30

(54) **OUTDOOR CABINET**
FREILUFTSCHRANK
ARMOIRE EXTÉRIEURE

(30) Priority: 15.02.2023 CN 202320279009 U
(43) Date of publication of application: 21.08.2024
(73) Proprietor: Sungrow Energy Storage Technology Co., Ltd., Hefei, Anhui 230088 (CN)
(72) Inventor: PEI, Yilin, Hefei, 230088 (CN)
(74) Representative: Rooney, John-Paul

(56) References cited:
- EP-A1- 0 961 377
- DE-U1- 202007 005 423
- US-A1- 2005 174 020
- US-B2- 10 779 422

## Description

### FIELD

The present application relates to the technical field of outdoor cabinets, and in particular to an outdoor cabinet.

### BACKGROUND

With the improvement of people's living standards, the requirements for outdoor cabinets also increase. Since outdoor cabinets are in an outdoor environment where rainfall, snowfall, and strong winds may occur at any time, the requirements of waterproof performance and corrosion resistance of outdoor cabinets are high. A sealing and waterproof structure of the conventional outdoor cabinet generally employs a self-clamping sealing strip, the sealing strip is clamped into a flange of a door frame, and after the door is closed and a door lock is clamped well, the sealing strip is compressed to seal the outdoor cabinet.

However, when the above structure is used to seal the outdoor cabinet, the requirements for machining technology are high. Specifically, the flange needs to be carefully polished during machining and manufacturing to ensure the roughness of the flange. However, the space at the inner side of the flange is limited, leading to difficulty in polishing. If the flange is not polished well, the sealing strip may not be tightly clamped in the flange, resulting in water backflow and water leakage from the inside of the sealing strip. In addition, a transition arc weldment that connects a vertical flange and a horizontal flange may be deformed by a force after being welding, so it is necessary to strictly control the welding process to ensure flatness and surface roughness of the weldment at the arc corners after welding; otherwise, a gap may exist between the flange and the sealing strip after the sealing strip is clamped, which leads to water leakage. Therefore, in order to meet the machining requirements, a large amount of manpower and material resources are required to handle the machining process, which greatly increases the processing and manufacturing costs.

US 10,779,422 B2 discloses high-moisture integrity wash-down enclosures for critical equipment which includes a housing wall structure having a peripheral edge defining a corresponding door opening, a shiftable door having a peripheral margin serves to cover the opening. The edge and margin cooperatively define a sealing zone having therein a sealing assembly. The assembly includes a primary outer seal, an innermost, generally U-shaped gutter, and a secondary inner seal. The out seal is disposed between the door and wall structure, whereas the inner seal is located between the gutter and the inner surface of the door.

EP 0961377 A1 discloses a housing which has a frame delimiting an opening, and a door designed to close the opening. The frame is fitted with a projecting edge on which is placed a flexible sealing strip. The sealing strip has a U shaped fixing part which engages onto the edge and a flexible sealing part. The door has an internal face having a peripheral edge against which the sealing part is applied.

US 2005/0174020 A1 discloses a profile that, from the outside, constitutes the means of support for the closings and accessories, while on the inside, the same structure configures the struts for the assembly of components and electric and electronic devices, in addition to which this profile presents a cross section with a geometry defined by a central core in the tubular shape with a quadrangular section, where the vertex is oriented to the inside of the cabinet, while the opposite vertex is oriented to the outside of this cabinet, and these two vertexes are formed by single walls, which does not apply to the other two remaining vertexes and, which are defined by the junction of the sheet that forms the first two vertexes and from this point on, the double walls are extended in a coplanar position in relation to the adjacent walls of the vertex, forming opposite rims, whose ends are perpendicularly folded forming short ends which, besides being grooved, are also distanced in parallel from the adjacent walls of the vertex, whose wall includes a projection perpendicularly oriented to the outside, configuring a perpendicular rim, finalizing the configuration of a profile that permits the assembly of structures which, in turn, receives different closings and doors, configuring cabinets/enclosures or boxes.

DE 202007005423 U1 discloses a profiled seal to be mounted in thin-walled cabinets or the like. Said seal comprises a U-shaped supporting profile for encompassing an edge of the thin wall and at least one sealing profile extending from at least one U-shaped limb (clamping lip) of the supporting profile for sealing the gap between the edge of the thin wall and a surface resting on the edge, such as a door frame or door leaf. The profiled seal is characterized by a guided corner portion forming for the profiled seal a graduated circle edge, such as a quarter arc edge, in the area of a corner, such as a 90 corner, said quarter arc edge having a radius with dimensions which are chosen such that the profiled seal can be guided about this radius without distortions or the loss of tightness.

### SUMMARY

The main purpose of the present application is to provide an outdoor cabinet to solve the problem that when a conventional waterproof structure is used for sealing the outdoor cabinet, a large amount of manpower and material resources are required to handle the machining process in order to meet the machining requirements, which results in high processing and manufacturing costs.

In order to achieve the above purpose, an outdoor cabinet is provided according to one aspect of the present application. The outdoor cabinet includes a cabinet body, a cabinet door being connected to the cabinet body, a flange structure being arranged on the cabinet body, and a sealing structure, where the sealing structure includes a groove, and the flange structure is clamped in the groove; a flange drainage gap is provided at the flange structure, and an auxiliary drainage gap is provided at the sealing structure, the flange drainage gap and the auxiliary drainage gap are arranged in positional correspondence with each other, and flange drainage gap and the auxiliary drainage gap are configured to discharge water entering the groove.

In an embodiment, the sealing structure further includes a groove, the groove includes a first side plate, a bottom plate, and a second side plate connected in sequence. The auxiliary drainage gap is provided at the first side plate, and the second side plate abuts against the flange structure for sealing.

In an embodiment, the number of flange drainage gaps is at least two, the at least two flange drainage gaps are provided at a bottom of the flange structure, where at least one of the flange drainage gaps is located at a first side of the flange structure, and at least another one of the flange drainage gaps is located at a second side of the flange structure.

In an embodiment, the flange drainage gap includes a first drainage gap and a second drainage gap, and the auxiliary drainage gap includes a third drainage gap and a fourth drainage gap. The first drainage gap and the third drainage gap are arranged in positional correspondence with each other, the second drainage gap and the fourth drainage gap are arranged in positional correspondence with each other, and the first drainage gap is located above the second drainage gap.

In an embodiment, the flange structure includes a transition arc structure, a vertical flange, and a horizontal flange. The vertical flange is connected to the horizontal flange through the transition arc structure, the first drainage gap is formed at the vertical flange, and the second drainage gap is formed at the horizontal flange.

In an embodiment, the third drainage gap is formed at the first side plate or the second side plate, and the fourth drainage gap is formed at the first side plate or the second side plate.

In an embodiment, the first drainage gap is located at a first end of the transition arc structure, and the second drainage gap is located at a second end of the transition arc structure.

In an embodiment, the groove includes an arc section, the arc section is located at a bottom of the sealing structure, and the arc section is configured to match the transition arc structure.

In an embodiment, an area of the auxiliary drainage gap is greater than an area of the flange drainage gap.

In an embodiment, the groove is a U-shaped groove, and a distance between the first side plate and the second side plate gradually decreases along a direction away from the bottom plate.

According to the technical solution of the present application, the flange structure and the sealing structure are provided, the flange structure is provided with the flange drainage gap and the sealing structure is provided with the auxiliary drainage gap Water that leaks into the groove first flows along the groove to reach the bottom of the flange structure, after reaching the bottom, the water can be discharged through the flange drainage gap and the auxiliary drainage gap to ensure that water will not enter the interior of the outdoor cabinet. Moreover, water backflow and water leakage can be effectively avoided. Even if the flatness and the surface roughness of the flange structure do not meet the requirements, and there is a clearance between the sealing structure and the flange structure after the sealing structure is sleeved on the flange structure, the water entering the groove can still be discharged through the flange drainage gap and the auxiliary drainage gap. Therefore, the requirements for the flatness and the roughness of the flange structure can be effectively reduced, thereby reducing the processing and manufacturing costs.

### BRIEF DESCRIPTION OF THE DRAWINGS

The drawings that constitute a part of the present application are used to provide a further understanding of the present application. The exemplary embodiments of the present application and descriptions thereof are used to illustrate the present application and do not constitute an improper limitation to the present application.
Figure 1 is a schematic view showing the structure of part of an outdoor cabinet according to an embodiment of the present application;
Figure 2 is a schematic view showing the structure of part of an outdoor cabinet according to an embodiment of the present application;
Figure 3 is an enlarged schematic view showing the structure of a portion A in Figure 2;
Figure 4 is a schematic view showing the whole structure of a sealing structure according to an embodiment of the present application; and
Figure 5 is an enlarged schematic view showing the structure of a portion B in Figure 4.

### Reference numerals:

| | | | |
|---|---|---|---|
| 10 | cabinet body, | 20 | flange structure, |
| 21 | flange drainage gap, | 211 | first drainage gap, |
| 212 | second drainage gap, | 22 | transition arc structure, |
| 23 | vertical flange, | 24 | horizontal flange, |
| 30 | sealing structure, | 31 | groove, |
| 311 | first side plate, | 312 | second side plate, |
| 313 | bottom plate, | 314 | arc section, |
| 32 | auxiliary drainage gap, | 321 | third drainage gap, |
| 322 | fourth drainage gap. | | |

### DETAILED DESCRIPTION OF THE EMBODIMENTS

It should be noted that, when there's no conflict, the embodiments and features thereof in the present application can be combined with one another. The present application is described in detail below with reference to the drawings and the embodiments.

The conventional outdoor cabinet employs a sealing strip to wrap a flange for sealing. In order to ensure the sealing effect of the outdoor cabinet, it is necessary to ensure the roughness of the inside and outside of the flange during processing and manufacturing. However, welding spot and welding slag may inevitably appear at the surface of the flange after welding, and at this time, it is necessary to carefully polish the surface of the flange to ensure the roughness of the surface of the flange. But the space at the inner side of the flange is limited, and the polishing is very difficult. If the flanging is not polished well, the sealing strip may not be tightly clamped in the flange, resulting in water backflow and water leakage from the inside of the sealing strip. In addition, a transitional arc weldment that connects a vertical flange and a horizontal flange is easy to be deformed by a force during welding, so it is necessary to strictly control the welding process to ensure flatness and surface roughness requirements of the arc weldment; otherwise, there is a clearance between the flange and the sealing strip after the sealing strip is clamped, leading to water leakage. In view of the above problems, the manufacturers have spent a lot of manpower and material resources to deal with the machining process, which greatly increases the processing and manufacturing costs.

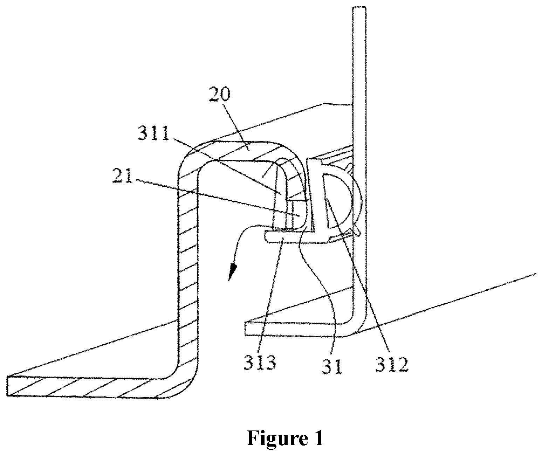

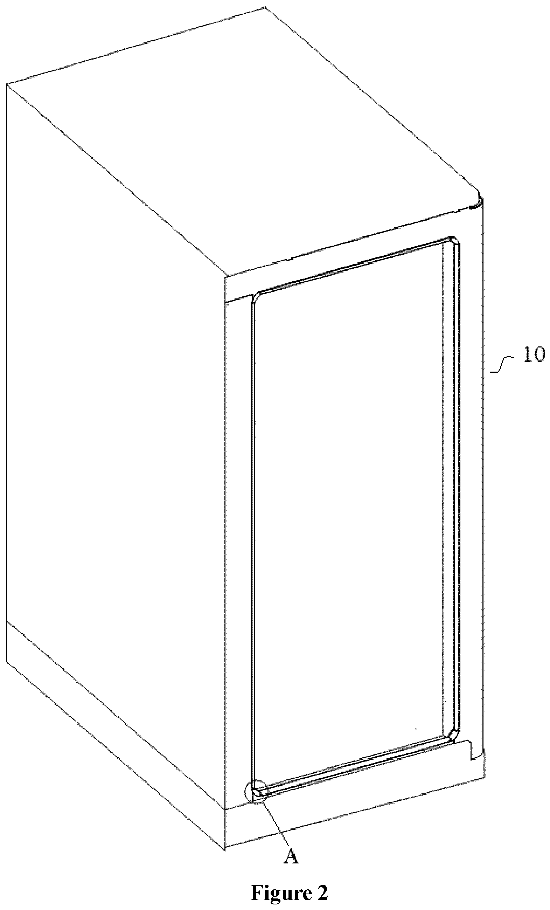

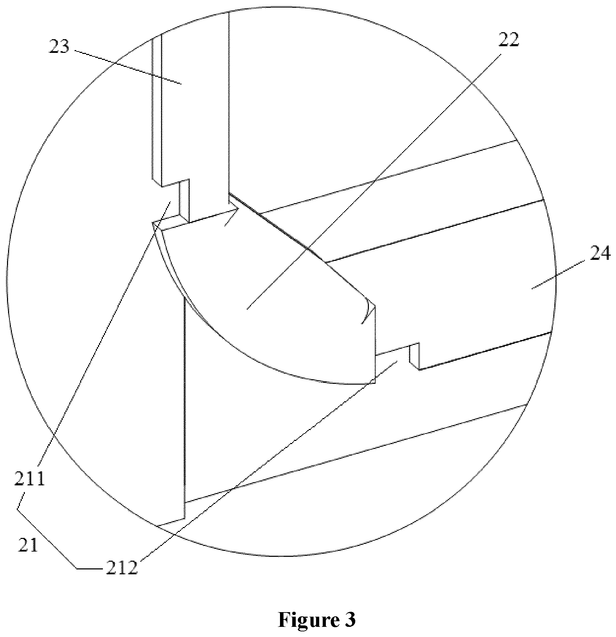

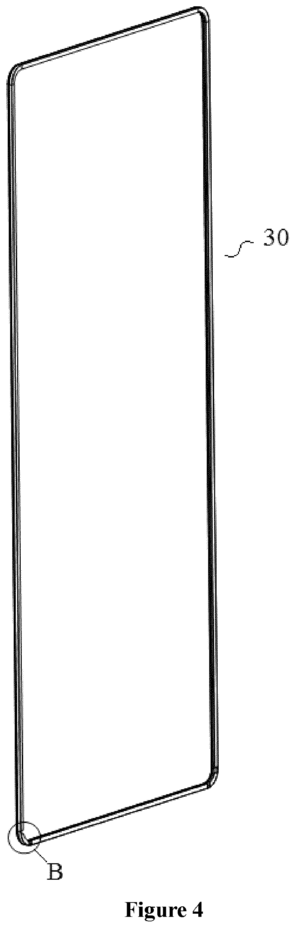

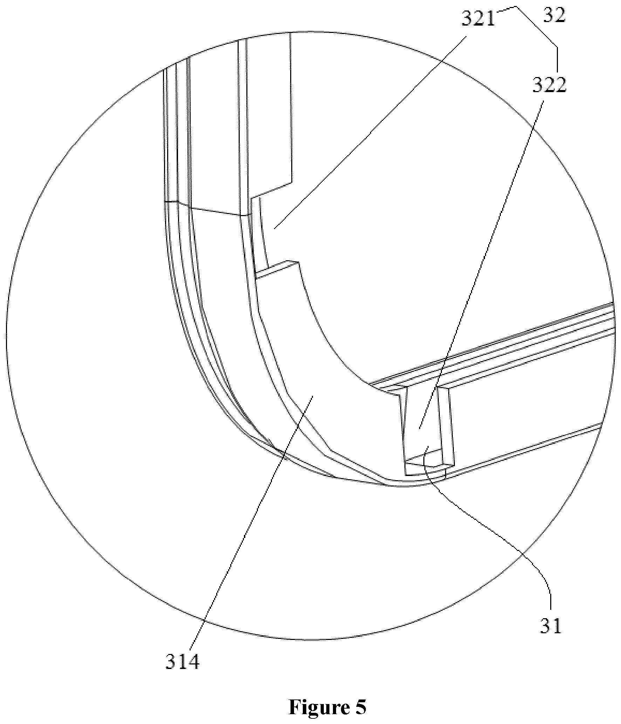

With reference to Figures 1 to 5, an outdoor cabinet is provided according to the present application. The outdoor cabinet includes a cabinet body 10, a cabinet door, a flange structure 20 and a sealing structure 30. The cabinet door is connected to the cabinet body 10, and the flange structure 20 is arranged on the cabinet body 10. The sealing structure 30 includes a groove 31, and the flange structure 20 is clamped in the groove 31. The flange structure 20 is provided with a flange drainage gap 21, the sealing structure 30 is provided with an auxiliary drainage gap 32, and the flange drainage gap 21 and the auxiliary drainage gap 32 are arranged in positional correspondence with each other. Water entering the groove 31 can be discharged through the flange drainage gap 21 and the auxiliary drainage gap 32. For example, the water may be discharged through the auxiliary drainage gap 32 first and then the flange drainage gap 21.

In the embodiment, the flange drainage gap 21 is provided at a bottom of the flange structure 20, and the sealing structure 30 is sleeved on the flange structure 20. The flange drainage gap 21 of the flange structure 20 positionally corresponds to the auxiliary drainage gap 32 of the sealing structure 30. In rainy days, under the continuous impact of rainwater, some of the rainwater may leak into the groove 31 of the sealing structure 30. The rainwater flows along the flange structure 20 to a bottom of the groove 31. After reaching the bottom, the rainwater can be discharged through the flange drainage gap 21 and auxiliary drainage gap 32. The outflow path of the rainwater is shown as a curve with an arrow in Figure 1, the rainwater can be discharged timely out of the groove 31, to prevent the water entering the sealing structure 30 from being accumulated in the groove 31 and overflowing out of the sealing structure 30, thereby ensuring that water does not enter the interior of the outdoor cabinet. The above structure is simple and can effectively avoid water backflow and water leakage. Even if the flatness and the surface roughness of the flange structure 20 do not meet the requirements, and there is a clearance between the sealing structure 30 and the flange structure 20 after the sealing structure 30 is sleeved on the flange structure 20, the water entering the groove 31 of the sealing structure 30 can still be discharged in time through the flange drainage gap 21 and the auxiliary drainage gap 32. Therefore, the requirements for the flatness and the roughness of the flange structure 20 can be effectively reduced, thereby reducing the processing and manufacturing costs. The outdoor cabinet in the present application is used outdoors and has protection requirements, for example, the outdoor cabinet is an outdoor electrical cabinet, an outdoor power distribution cabinet or the like.

In the above embodiment, the flange structure 20 is arranged on the cabinet body 10, and the sealing structure 30 is arranged on the cabinet door. It should be noted that alternatively, the flange structure 20 may be arranged on the cabinet door, while the sealing structure 30 being arranged on the cabinet body 10, in this case, when the cabinet door is closed, the flange structure 20 is clamped in the groove 31 to realize sealing of the outdoor cabinet.

In an embodiment of the present application, the sealing structure 30 is a sealing strip.

With reference to Figures 1 to 5, in an embodiment of the present application, the sealing structure 30 further includes a groove 31. The groove 31 includes a first side plate 311, a bottom plate 313, and a second side plate 312 that are connected in sequence. The auxiliary drainage gap 32 is formed at the first side plate 311. The second side plate 312 abuts against the flange structure 20 for sealing.

In the embodiment, the first side plate 311 is fitted to a surface of the flange structure 20 close to the cabinet body 10, and the second side plate 312 is fitted to another surface of the flange structure 20 away from the cabinet body 10. The auxiliary drainage gap 32 is formed at the first side plate 311. The rainwater that leaks into the groove 31 flows along the flange structure 20 to the bottom of the groove 31, and after reaching the bottom, the rainwater passes through the flange drainage gap 21 and the auxiliary drainage gap 32 in sequence to be discharged. The second side plate 312 abuts against the flange structure 20 to realize the sealing of the outdoor cabinet.

As shown in Figures 1 to 5, in an embodiment of the present application, the number of the flange drainage gap 21 is at least two, and the at least two flange drainage gaps 21 are formed at the bottom of the flange structure 20. At least one of the flange drainage gaps 21 is located on a first side of the flange structure 20, and at least another one of the flange drainage gaps 21 is located on a second side of the flange structure 20.

In the embodiment, the flange drainage gaps 21 are formed at the bottom of the flange structure 20. The first side of the flange structure 20 corresponds to a left side of the cabinet body 10, and the second side of the flange structure 20 corresponds to a right side of the cabinet body 10. At least one flange drainage gap 21 is formed on each of the first side and the second side of the flange structure 20, and a left end and a right end of the bottom of the flange structure 20 are each provided with the flange drainage gap 21. The auxiliary drainage gaps 32 are provided in one-to-one correspondence with the flange drainage gaps 21. In this way, corresponding positions of the sealing structure 30 are provided with the auxiliary drainage gaps 32, the water that leaks into the sealing structure 30 can be discharged through the flange drainage gaps 21 and the auxiliary drainage gaps 32 formed at the left end and the right end of the bottom of the cabinet body 10, thus the drainage is faster and the sealing effect is better.

As shown in Figures 1 to 5, in an embodiment of the present application, the flange drainage gap 21 includes a first drainage gap 211 and a second drainage gap 212, the auxiliary drainage gap 32 includes a third drainage gap 321 and a fourth drainage gap 322. The first drainage gap 211 positionally corresponds to the third drainage gap 321, and the second drainage gap 212 positionally corresponds to the fourth drainage gap 322. The first drainage gap 211 is formed at an outer edge of a vertical flange 23, the second drainage gap 212 is formed at a lower edge of the horizontal flange 24, and the first drainage gap 211 is located above the second drainage gap 212. The flange structure 20 includes a transition arc structure 22, the vertical flange 23, and the horizontal flange 24. The vertical flange 23 is connected to the horizontal flange 24 through the transition arc structure 22. The first drainage gap 211 is formed at the vertical flange 23, the second drainage gap 212 is formed at the horizontal flange 24, the first drainage gap 211 is located at a first end of the transition arc structure 22, and the second drainage gap 212 is located at a second end of the transition arc structure 22.

In the embodiment, the first drainage gap 211 is formed at the vertical flange 23, the second drainage gap 212 is formed at the horizontal flange 24, the first drainage gap 211 corresponds to the third drainage gap 321 positionally, the second drainage gap 212 corresponds to the fourth drainage gap 322 positionally, and the vertical flange 23 is connected to the horizontal flange 24 through the transition arc structure 22. Since the first drainage gap 211 is located above the second drainage gap 212, most of the water leaking into the sealing structure 30 from top to bottom first flows out through the first drainage gap 211 and the third drainage gap 321, a small amount of the water that cannot be discharged in time flows along the transition arc structure 22 to the horizontal flange 24, and then flows out through the second drainage gap 212 and the fourth drainage gap 322. With the above arrangement, even if the roughness of the flange structure 20 and the flatness and the roughness of the transition arc structure 22 do not meet the requirements, the water that leaks into the sealing structure 30 can be discharged in time, so that the sealing and waterproof effect of the outdoor cabinet can be ensured, and the manufacturability can be greatly improved.

With reference to Figures 1 to 5, in an embodiment of the present application, the third drainage gap 321 is formed at the first side plate 311 or the second side plate 312, and the fourth drainage gap 322 is formed at the first side plate 311 or the second side plate 312.

In the embodiment, the third drainage gap 321 may be formed at the first side plate 311, or may be formed at the second side plate 312, and the fourth drainage gap 322 may be formed at the first side plate 311, or may be formed at the second side plate 312. As the first side plate 311 is fitted to the surface of the flange structure 20 close to the cabinet body 10, and the second side plate 312 is fitted to the surface of the flange structure 20 away from the cabinet body 10, therefore, on the premise that the sealing effect is ensured, the third drainage gap 321 and the fourth drainage gap 322 are preferably formed at the first side plate 311, to prevent the influence on a front appearance of the sealing structure 30.

With reference to Figures 1 to 5, in an embodiment of the present application, the groove 31 includes an arc section 314. The arc section 314 is located at the bottom of the sealing structure 30, and the arc section 314 can match the transition arc structure 22.

In the embodiment, the groove 31 of the sealing structure 30 includes the arc section 314 and can match the transition arc structure 22. With the above arrangement, it can be ensured that the sealing structure 30 is sleeved on the flange structure 20 more closely, to ensure the sealing effect.

With reference to Figures 1 to 5, in an embodiment of the present application, an area of the auxiliary drainage gap 32 is greater than an area of the flange drainage gap 21.

With the above arrangement, the water that leaks into the interior of the sealing structure 30 can be discharged more easily.

With reference to Figures 1 to 5, in an embodiment of the present application, the groove 31 is a U-shaped groove 31, and a distance between the first side plate 311 and the second side plate 312 gradually decreases along a direction away from the bottom plate 313.

With the above arrangement, it can be ensured that after the sealing structure 30 is sleeved on the flange structure 20, the sealing structure 30 is not prone to fall off or play relative to the flange structure 20, and thus has better structural stability.

From the above description, it can be seen that the embodiments of the present application achieve the following technical effects: the flange structure and the sealing structure are provided, the flange structure is provided with the flange drainage gap, and the sealing structure is provided with the auxiliary drainage gap. The water that leaks into the groove first flows along the groove to the bottom of the flange structure, after reaching the bottom, the water can be discharged through the flange drainage gap and the auxiliary drainage gap, to ensure that no water enters the interior of the outdoor cabinet, and water backflow and water leakage can be effectively avoided. Even if the flatness and the surface roughness of the flange structure do not meet the requirements, and there is a clearance between the sealing structure and the flange structure after the sealing structure is sleeved on the flange structure, the water entering the groove can still be discharged through the flange drainage gap and the auxiliary drainage gap. Therefore, the requirements for the flatness and the roughness of the flange structure can be effectively reduced, and thus the processing and manufacturing costs can be reduced.

It should be noted that, the terms used herein are only for describing the specific embodiments, rather than intending to limit the exemplary embodiments according to the present application. As used herein, a singular form is also intended to include a plural form unless the context explicitly indicates otherwise. In addition, it should be understood that when the terms the terms "comprises" and/or "includes" are used in this specification, it is indicated that there are a feature, a step, an operation, a device, a component, and/or a combination thereof.

## Claims

1. An outdoor cabinet, comprising:
a cabinet body (10);
a cabinet door being connected to the cabinet body (10);
a flange structure (20) being arranged on the cabinet body (10); and
a sealing structure (30), wherein the sealing structure (30) comprises a groove (31), the flange structure (20) is clamped in the groove (31), an auxiliary drainage gap (32) is provided at the sealing structure (30),
**characterized in that**
a flange drainage gap (21) is provided at the flange structure (20), and
the flange drainage gap (21) and the auxiliary drainage gap (32) are arranged in positional correspondence with each other, and the flange drainage gap (21) and the auxiliary drainage gap (32) are configured to discharge water entering the groove (31).

2. The outdoor cabinet according to claim 1, wherein the groove (31) comprises a first side plate (311), a bottom plate (313), and a second side plate (312) connected in sequence, the auxiliary drainage gap (32) is provided at the first side plate (311), and the second side plate (312) abuts against the flange structure (20) for sealing.

3. The outdoor cabinet according to claim 1, wherein the number of flange drainage gaps (21) is at least two, the at least two flange drainage gaps (21) are provided at a bottom of the flange structure (20), wherein at least one of the at least two flange drainage gaps (21) is located on a first side of the flange structure (20), and at least another one of the at least two flange drainage gaps (21) is located on a second side of the flange structure (20).

4. The outdoor cabinet according to claim 2, wherein the flange drainage gap (21) comprises a first drainage gap (211) and a second drainage gap (212), the auxiliary drainage gap (32) comprises a third drainage gap (321) and a fourth drainage gap (322), wherein the first drainage gap (211) and the third drainage gap (321) are arranged in positional correspondence with each other, and the second drainage gap (212) and the fourth drainage gap (322) are arranged in positional correspondence with each other.

5. The outdoor cabinet according to claim 4, wherein the flange structure (20) comprises a transition arc structure (22), a vertical flange (23), and a horizontal flange (24), wherein the vertical flange (23) is connected to the horizontal flange (24) through the transition arc structure (22), the first drainage gap (211) is formed at the vertical flange (23), the second drainage gap (212) is formed at the horizontal flange (24), and the first drainage gap (211) is located above the second drainage gap (212).

6. The outdoor cabinet according to claim 4, wherein the third drainage gap (321) is formed at the first side plate (311) or the second side plate (312), and the fourth drainage gap (322) is formed at the first side plate (311) or the second side plate (312).

7. The outdoor cabinet according to claim 5, wherein the first drainage gap (211) is located at a first end of the transition arc structure (22), and the second drainage gap (212) is located at a second end of the transition arc structure (22).

8. The outdoor cabinet according to claim 5, wherein the groove (31) comprises an arc section (314), the arc section (314) is located at a bottom of the sealing structure (30), and the arc section (314) is configured to match the transition arc structure.

9. The outdoor cabinet according to any one of claims 4 to 8, wherein an area of the auxiliary drainage gap (32) is greater than an area of the flange drainage gap (21).

10. The outdoor cabinet according to claim 2, wherein the groove (31) is a U-shaped groove, and a distance between the first side plate (311) and the second side plate (312) gradually decreases along a direction away from the bottom plate (313).

## Patentansprüche

1. Freiluftschrank, umfassend:
einen Schrankkörper (10);
eine Schranktür, die mit dem Schrankkörper (10) verbunden ist;
eine Flanschstruktur (20), die an dem Schrankkörper (10) angeordnet ist; und
eine Dichtungsstruktur (30), wobei die Dichtungsstruktur (30) eine Nut (31) umfasst, die Flanschstruktur (20) in der Nut (31) eingeklemmt ist, ein Hilfsentwässerungsspalt (32) an der Dichtungsstruktur (30) bereitgestellt ist,
**dadurch gekennzeichnet, dass**
ein Flanschentwässerungsspalt (21) an der Flanschstruktur (20) bereitgestellt ist, und
der Flanschentwässerungsspalt (21) und der Hilfsentwässerungsspalt (32) in Positionsentsprechung zueinander angeordnet sind, und der Flanschentwässerungsspalt (21) und der Hilfsentwässerungsspalt (32) ausgebildet sind, um Wasser, das in die Nut (31) eintritt, abzuführen.

2. Freiluftschrank nach Anspruch 1, wobei die Nut (31) eine erste Seitenplatte (311), eine Bodenplatte (313) und eine zweite Seitenplatte (312), die der Reihe nach verbunden sind, umfasst, der Hilfsentwässerungsspalt (32) an der ersten Seitenplatte (311) bereitgestellt ist, und die zweite Seitenplatte (312) zur Abdichtung an der Flanschstruktur (20) anliegt.

3. Freiluftschrank nach Anspruch 1, wobei die Anzahl von Flanschentwässerungsspalten (21) mindestens zwei ist, die mindestens zwei Flanschentwässerungsspalten (21) an einem Boden der Flanschstruktur (20) bereitgestellt sind, wobei sich mindestens einer der mindestens zwei Flanschentwässerungsspalten (21) auf einer ersten Seite der Flanschstruktur (20) befindet und sich mindestens ein anderer der mindestens zwei Flanschentwässerungsspalten (21) auf einer zweiten Seite der Flanschstruktur (20) befindet.

4. Freiluftschrank nach Anspruch 2, wobei der Flanschentwässerungsspalt (21) einen ersten Entwässerungsspalt (211) und einen zweiten Entwässerungsspalt (212) umfasst, der Hilfsentwässerungsspalt (32) einen dritten Entwässerungsspalt (321) und einen vierten Entwässerungsspalt (322) umfasst, wobei der erste Entwässerungsspalt (211) und der dritte Entwässerungsspalt (321) in Positionsentsprechung zueinander angeordnet sind und der zweite Entwässerungsspalt (212) und der vierte Entwässerungsspalt (322) in Positionsentsprechung zueinander angeordnet sind.

5. Freiluftschrank nach Anspruch 4, wobei die Flanschstruktur (20) eine Übergangsbogenstruktur (22), einen vertikalen Flansch (23) und einen horizontalen Flansch (24) umfasst, wobei der vertikale Flansch (23) über die Übergangsbogenstruktur (22) mit dem horizontalen Flansch (24) verbunden ist, der erste Entwässerungsspalt (211) an dem vertikalen Flansch (23) gebildet ist, der zweite Entwässerungsspalt (212) an dem horizontalen Flansch (24) gebildet ist und der erste Entwässerungsspalt (211) oberhalb des zweiten Entwässerungsspalts (212) angeordnet ist.

6. Freiluftschrank nach Anspruch 4, wobei der dritte Entwässerungsspalt (321) an der ersten Seitenplatte (311) oder der zweiten Seitenplatte (312) gebildet ist, und der vierte Entwässerungsspalt (322) an der ersten Seitenplatte (311) oder der zweiten Seitenplatte (312) gebildet ist.

7. Freiluftschrank nach Anspruch 5, wobei der erste Entwässerungsspalt (211) an einem ersten Ende der Übergangsbogenstruktur (22) angeordnet ist und der zweite Entwässerungsspalt (212) an einem zweiten Ende der Übergangsbogenstruktur (22) angeordnet ist.

8. Freiluftschrank nach Anspruch 5, wobei die Nut (31) einen Bogenabschnitt (314) umfasst, der Bogenabschnitt (314) an einem Boden der Dichtungsstruktur (30) angeordnet ist, und der Bogenabschnitt (314) ausgebildet ist, mit der Übergangsbogenstruktur übereinzustimmen.

9. Freiluftschrank nach einem der Ansprüche 4 bis 8, wobei eine Fläche des Hilfsentwässerungsspalts (32) größer ist als eine Fläche des Flanschentwässerungsspalts (21).

10. Freiluftschrank nach Anspruch 2, wobei die Nut (31) eine U-förmige Nut ist und ein Abstand zwischen der ersten Seitenplatte (311) und der zweiten Seitenplatte (312) entlang einer Richtung weg von der Bodenplatte (313) allmählich abnimmt.

## Revendications

1. Armoire extérieure, comprenant :
un corps (10) d'armoire ;
une porte d'armoire qui est reliée au corps (10) d'armoire ;
une structure de bride (20) qui est agencée sur le corps (10) d'armoire ; et
une structure d'étanchéité (30), dans laquelle la structure d'étanchéité (30) comprend une rainure (31), la structure de bride (20) est serrée dans la rainure (31), un espace de drainage auxiliaire (32) est prévu au niveau de la structure d'étanchéité (30),
**caractérisée en ce que**
un espace de drainage (21) de bride est prévu au niveau de la structure de bride (20), et
l'espace de drainage (21) de bride et l'espace de drainage auxiliaire (32) sont agencés en correspondance de position l'un avec l'autre, et l'espace de drainage (21) de bride et l'espace de drainage auxiliaire (32) sont configurés pour évacuer l'eau entrant dans la rainure (31).

2. Armoire extérieure selon la revendication 1, dans laquelle la rainure (31) comprend une première plaque latérale (311), une plaque de fond (313) et une deuxième plaque latérale (312) reliées en séquence, l'espace de drainage auxiliaire (32) est prévu au niveau de la première plaque latérale (311), et la deuxième plaque latérale (312) vient en butée contre la structure de bride (20) pour l'étanchéité.

3. Armoire extérieure selon la revendication 1, dans laquelle le nombre d'espaces de drainage (21) de bride est d'au moins deux, les au moins deux espaces de drainage (21) de bride sont prévus au niveau d'un fond de la structure de bride (20), dans laquelle au moins un des au moins deux espaces de drainage (21) de bride se situe sur un premier côté de la structure de bride (20), et au moins un autre des au moins deux espaces de drainage (21) de bride se situe sur un deuxième côté de la structure de bride (20).

4. Armoire extérieure selon la revendication 2, dans laquelle l'espace de drainage (21) de bride comprend un premier espace de drainage (211) et un deuxième espace de drainage (212), l'espace de drainage auxiliaire (32) comprend un troisième espace de drainage (321) et un quatrième espace de drainage (322), dans laquelle le premier espace de drainage (211) et le troisième espace de drainage (321) sont agencés en correspondance de position l'un avec l'autre, et le deuxième espace de drainage (212) et le quatrième espace de drainage (322) sont agencés en correspondance de position l'un avec l'autre.

5. Armoire extérieure selon la revendication 4, dans laquelle la structure de bride (20) comprend une structure en arc de transition (22), une bride verticale (23) et une bride horizontale (24), dans laquelle la bride verticale (23) est reliée à la bride horizontale (24) par l'intermédiaire de la structure en arc de transition (22), le premier espace de drainage (211) est formé au niveau de la bride verticale (23), le deuxième espace de drainage (212) est formé au niveau de la bride horizontale (24), et le premier espace de drainage (211) se situe au-dessus du deuxième espace de drainage (212).

6. Armoire extérieure selon la revendication 4, dans laquelle le troisième espace de drainage (321) est formé au niveau de la première plaque latérale (311) ou de la deuxième plaque latérale (312), et le quatrième espace de drainage (322) est formé au niveau de la première plaque latérale (311) ou de la deuxième plaque latérale (312).

7. Armoire extérieure selon la revendication 5, dans laquelle le premier espace de drainage (211) se situe à une première extrémité de la structure en arc de transition (22), et le deuxième espace de drainage (212) se situe à une deuxième extrémité de la structure en arc de transition (22).

8. Armoire extérieure selon la revendication 5, dans laquelle la rainure (31) comprend une section en arc (314), la section en arc (314) se situe au niveau d'un fond de la structure d'étanchéité (30), et la section en arc (314) est configurée pour correspondre à la structure en arc de transition.

9. Armoire extérieure selon l'une quelconque des revendications 4 à 8, dans laquelle une surface de l'espace de drainage auxiliaire (32) est supérieure à une surface de l'espace de drainage (21) de bride.

10. Armoire extérieure selon la revendication 2, dans laquelle la rainure (31) est une rainure en forme de U, et une distance entre la première plaque latérale (311) et la deuxième plaque latérale (312) diminue progressivement le long d'une direction s'éloignant de la plaque de fond (313).
